# EUROPEAN PATENT APPLICATION

(11) **EP 1 580 247 A1**
(43) Date of publication of application: **28.09.2005**
(21) Application number: 05006272.8
(22) Date of filing: 22.03.2005
(51) Int. Cl.: C09K 3/14, C09G 1/02, H01L 21/00

(54) **Polishing composition and polishing method**

(30) Priority: 22.03.2004 JP 2004083600
(71) Applicant: FUJIMI INCORPORATED, Aichi 452-8502 (JP)
(72) Inventor: Oh, Junhui c/o Fujimi Incorporated, Nishikasugai-gun Aichi 452-8502 (JP); Kawamura, Atsunori c/o Fujimi Incorporated, Nishikasugai-gun Aichi 452-8502 (JP); Matsuda, Tsuyoshi c/o Fujimi Incorporated, Nishikasugai-gun Aichi 452-8502 (JP); Hirano, Tatsuhiko c/o Fujimi Incorporated, Nishikasugai-gun Aichi 452-8502 (JP); Sakai, Kenji c/o Fujimi Incorporated, Nishikasugai-gun Aichi 452-8502 (JP); Hori, Katsunobu c/o Fujimi Incorporated, Nishikasugai-gun Aichi 452-8502 (JP)
(74) Representative: Reinhard - Skuhra - Weise & Partner

(57) **Abstract**

A polishing composition contains a surface irregularity-inhibitor, silicon dioxide, an acid, an oxidant, and water. The surface irregularity-inhibitor is at least one selected from, for example, stored polysaccharides and extracellular polysaccharides. The silicon dioxide is, for example, colloidal silica, fumed silica, or precipitated silica. The acid is at least one selected from, for example, nitric acid, hydrochloric acid, sulfuric acid, lactic acid, acetic acid, oxalic acid, citric acid, malic acid, succinic acid, butyric acid, and malonic acid. The oxidant is, for example, hydrogen peroxide, persulfate, periodate, perchlorate, nitrate salt, or an oxidative metallic salt. The polishing composition can be suitably used in polishing for forming wiring in a semiconductor device.

## Description

### BACKGROUND OF THE INVENTION

The present invention relates to a polishing composition for use, for example, in polishing for forming wiring in a semiconductor device, and a polishing method using such a polishing composition.

A high-integration and high-speed ULSI is manufactured in accordance with a fine design rule. Recently, in order to suppress an increase in wiring resistance, caused by fine wiring in a semiconductor device, a copper containing metal has been used as a wiring material.

Since the Copper containing metal has the property of being difficult to process by anisotropic etching, wiring made of the copper containing material is formed by the Chemical Mechanical Polishing (CMP) process in the following manner. First, a barrier film made of a compound containing tantalum is provided on an insulating film having trenches. Next, a conductive film made of the copper containing metal is provided on the barrier film so as to at least fill up the trenches. Then, the portion of the conductive film and barrier film, which is positioned outside the trenches, is removed by CMP. As a result, the portion of the conductive film, which is positioned in the trenches, is left on the insulating film and will act as wiring.

CMP for removing the portion of the conductive film and barrier film positioned outside the trenches is generally carried out in two stages, first and second polishing steps. In the first polishing step, a part of the portion of the conductive film, which is positioned outside the trenches, is removed by CMP so that the top surface of the barrier film is exposed. In .the subsequent second step, the residue of the portion of the conductive film, which is positioned outside the trenches, and the portion of the barrier film, which is positioned outside the trenches, are removed by CMP so that the top surface of the insulating film is exposed.

Japanese Laid-Open Patent Publication No. 2000-160139 discloses a first conventional polishing composition, which contains an abrasive, oxidant, reductant, and water. The oxidant and reductant have an action to accelerate polishing of the barrier film. Japanese Laid-Open Patent Publication No. 2001-89747 discloses a second conventional polishing composition, which contains a triazole derivative, which has an action to inhibit corrosion of the conductive film. Japanese Laid-Open Patent Publication No. 2001-247053 discloses a third conventional polishing composition, which contains an abrasive of silica having a primary particle diameter of 20 nm or less. Silica having a primary particle diameter of 20 nm or less has a high capability of polishing the conductive and barrier films.

When the first to third conventional polishing compositions are used in CMP in the second polishing step, a phenomenon called dishing occurs, where the level of the top surface of the conductive film lowers due to the conductive films are excessively polished. A phenomenon called fang also occurs, where the level of the top surface of the barrier film and insulating film lowers due to the barrier film and insulating film near the barrier film are excessively polished. When dishing and fang occur, the flatness of the surface of a semiconductor device largely impairs due to the polished device surface becomes uneven, thereby making it difficult to form multi-filmed wiring. Moreover, the dishing reduces the cross sectional of the wiring, thereby causing an increase in wiring resistance.

### SUMMARY OF THE INVENTION

It is an object of the present invention to provide a polishing composition that can be suitably used in polishing for forming wiring in a semiconductor device. It is another object of the present invention to provide a polishing method using such a polishing composition.

To achieve the foregoing and other objectives and in accordance with the purposes of the present invention, the present invention provides a polishing composition. The polishing composition, for use in polishing for forming wiring in a semiconductor device, contains a surface irregularity-inhibitor, silicon dioxide, an acid, an oxidant, and water.

The present invention also provides a polishing method that includes preparing the above polishing composition and polishing a subject to be polished with the prepared polishing composition in order to form wiring in a semiconductor device.

Other aspects and advantages of the invention will become apparent from the following description, illustrating by way of example the principle of the invention.

### BRIEF DESCRIPTION OF THE DRAWINGS

The invention, together with objects and advantages thereof, may best be understood by reference to the following description of the presently preferred embodiments together with the accompanying drawing, in which:
Fig. 1 to Fig. 3 are cross sectional views for explaining a polishing method according to one embodiment of the present invention;
Fig. 4 (a) is a cross sectional view illustrating a dishing at the end of the first polishing step;
Fig. 4 (b) is a cross sectional view illustrating a dishing at the end of the second polishing step;
Fig. 5 (a) is a cross sectional view illustrating a fang at the end of the second polishing step; and
Fig. 5 (b) is a partly magnified view illustrating a fang at the end of the second polishing step.

### DETAILED DESCRIPTION OF THE PREFERRED EMBODIMENTS

One embodiments of the present invention will now be described.

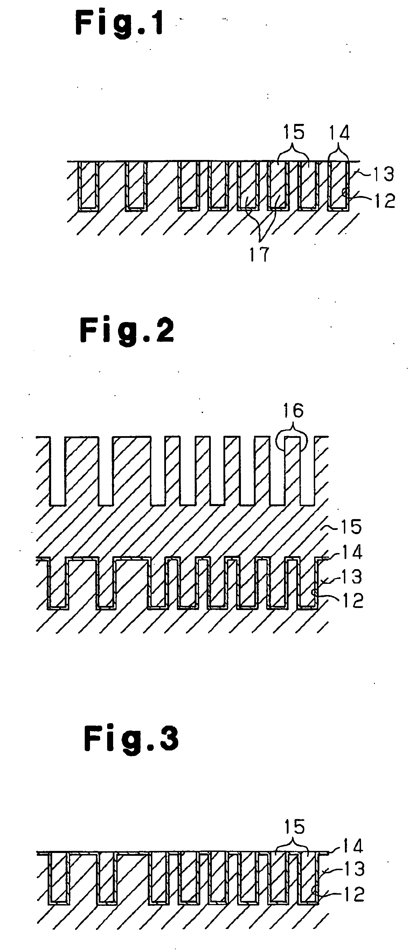

First, a method for forming wiring 17 (see Fig. 1) in a semiconductor device will be described. In forming wiring 17 in a semiconductor device, as shown in Fig. 2, a barrier film 14 and a conductive film 15 are first formed on an insulating film 13 having trenches 12.

The insulating film 13 may be a SiO₂ film, SiOF film or SiOC film. The insulating film 13 is formed using SiH₄, SiH₂C₁₂ or tetraethoxysilane (TEOS) by the Chemical Vapor Deposition (CVD). The trenches 12 are formed for example by the known lithography and pattern etching techniques so as to have a prescribed design pattern.

The barrier film 14 is formed on the insulating film 13 so as to cover the surface thereof in advance of formation of the conductive film 15. The barrier film 14 is formed, for example, by a sputtering method. It is preferred that the barrier film 14 has a sufficiently small thickness as compared to the depth of the trench 12. The barrier film 14 is formed, for example, of tantalum or a tantalum-containing compound, such as tantalum nitride.

The conductive film 15 is provided on the barrier film 14 so as to at least fill up the trenches 12. The conductive film 15 is formed, for example, by the Physical Vapor Deposition (PVD). The conductive film 15 is formed, for example, a copper containing metal. The copper containing metal may be copper, a copper-aluminum alloy or a copper-titanium alloy. The conductive film 15 that is formed on the insulating film 13 having the trenches 12 typically comprises, on the top surface, initial concave portions 16 to correspond to the trenches 12.

Then, the portions of the conductive film 15 and barrier film 14 positioned outside the trenches 12 are removed by CMP. CMP is carried out in two stages, first and second polishing steps. In the first polishing step, as shown in Fig. 3, a part of the portion of the conductive film 15, which is positioned outside the trenches 12 is removed by CMP so that the top surface of the barrier film 14 exposed. In the subsequent second step, as shown in Fig. 1, the residue of the portion of the conductive film 15, which is positioned outside the trenches 12, and the portion of the barrier film 14, which is positioned outside the trenches, are removed by CMP so that the top surface of the insulating film 13 is exposed. As a result, the portion of the conductive film 15, which is positioned inside trenches 12, is left on the insulating film 13 and will act as wiring 17. The barrier film 14 serves to prevent copper in the conductive film 15 (the wiring 17) from diffusing in the insulating film 13.

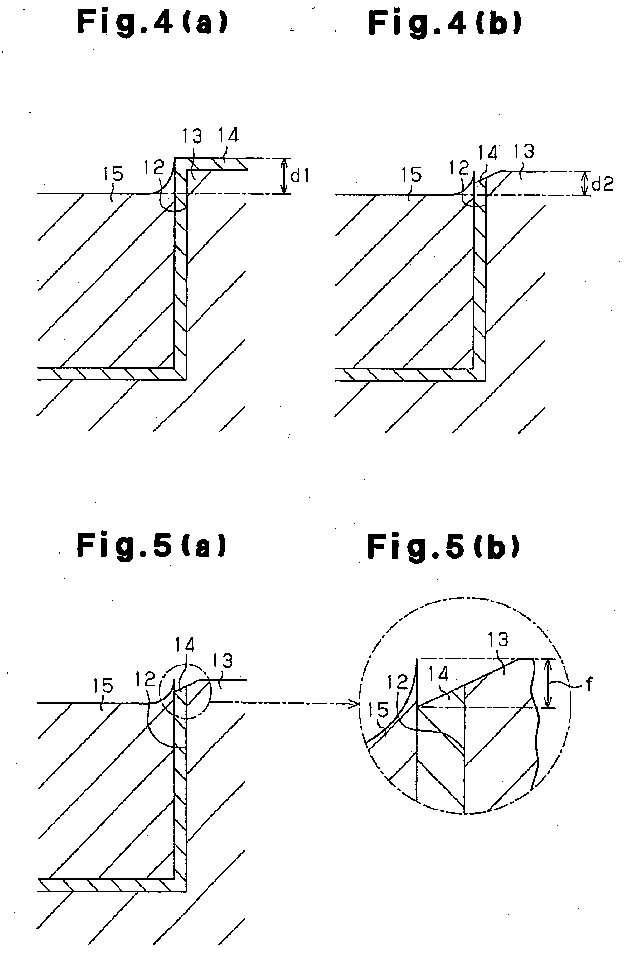

The degree of occurrence of dishing and fang in each of the polishing steps is indicated by the dishing depth and fang depth measured after each step as indexes. The dishing depth measured at the end of the first polishing step is the difference d1 between the top surface level of the conductive film 15 remaining on the insulating film 13 and that of the barrier film 14 outside of the trenches 12, as illustrated in Fig. 4 (a). The dishing depth measured at the end of the second polishing step is the difference d2 between the top surface level of the conductive film 15 remaining on the insulating film 13 and that of the insulating film 13, as illustrated in Fig. 4 (b). The fang depth measured at the end of each step is the difference f between the edge level of the conductive film 15 remaining on the insulating film 13 and the top surface level of the barrier film 14 adjacent to the edge, as illustrated in Figs. 5 (a) and (b).

A polishing composition of the present embodiment is for example used in the CMP of the second polishing step. The polishing composition contains a surface irregularity-inhibitor, silicon dioxide, an acid, an oxidant, and water.

The surface irregularity-inhibitor contained in the polishing composition acts to inhibit the occurrence of dishing and fang during the polishing step when a subject to be polished is polished with the polishing composition. It is considered that surface irregularity-inhibitor is selectively adsorbed on the barrier film 14 and conductive film 15 to form a coating film thereon. It is further considered that the coating film improves fluidity of the polishing composition flowing in the vicinity of the coating film, and thereby inhibits local retention and stagnation of the polishing composition, and thus inhibits the occurrence of dishing and fang.

The surface irregularity-inhibitor is preferably at least one selected from stored polysaccharides and extracellular polysaccharides, since they have high adsorptivity for the barrier film 14 and conductive film 15 and can easily form a coating film on these films. Examples of the stored polysaccharides include starch, amylopectin and glycogen. Examples of the extracellular polysaccharides include pullulan and elsinan. Among them, pullulan is preferable, since pullulan has a particularly strong action to inhibit the occurrence of dishing and fang. Pullulan is a water-soluble polysaccharide, and can be produced by culturing one species of black yeast in starch. The molecular weight of pullulan is preferably 300,000 or less, since solubility of pullulan in water improves. At the same time, the molecular weight of pullulan is preferably 100,000 or more, since the action of pullulan to inhibit the occurrence of dishing and fang enhances.

The content of the surface irregularity-inhibitor in the polishing composition is preferably 0.001% by mass or more, more preferably 0.01% by mass or more, most preferably 0.1% by mass or more, since the capability of the polishing composition for inhibiting the occurrence of dishing and fang improves. At the same time, the content of the surface irregularity-inhibitor is preferably 30% by mass or less, more preferably 20% by mass or less, most preferably 10% by mass or less, since the capability of the polishing composition for polishing the barrier film 14 is favorably maintained.

Silicon dioxide contained in the polishing composition acts as an abrasive for mechanically polishing the object to be polished. The silicon dioxide may be colloidal silica, fumed silica, or precipitated silica. Among them, colloidal silica or fumed silica is preferable, and colloidal silica is more preferable, since they have high dispersion stability and inhibit a reduction over time in the polishing capability of the polishing composition. The number of types of silicon dioxide contained in the polishing composition may be one or two or more.

The average particle diameter D_{N4} of silicon dioxide, which is determined by the laser diffraction scatting method, is preferably 0.01 µm or more, more preferably 0.03 µm or more, since the capability of the polishing composition for polishing the barrier film 14 improves. At the same time, the average particle diameter D_{N4} of silicon dioxide is preferably less than 0.5 µm, more preferably less than 0.3 µm, since the capability of the polishing composition for inhibiting the occurrence of dishing and fang improves.

It is preferred that the silicon dioxide be a mixture of a first silicon dioxide and a second dioxide, the average particle diameter of the second silicon dioxide is smaller than the average particle diameter of the first silicon dioxide. The average particle diameter D_{N4} of the first silicon dioxide is preferably 0.05 µm or more, more preferably 0.06 µm or more, since the capability of the polishing composition for polishing the barrier film 14 improves. At the same time, the average particle diameter D_{N4} of the first silicon dioxide is preferably 0.3 µm or less, more preferably 0.2 µm or less, since the capability of the polishing composition for inhibiting the occurrence of dishing and fang improves. The average particle diameter D_{N4} of the second silicon dioxide is preferably 0.01 µm or more, more preferably 0.02 µm or more, preferably less than 0.05 µm, more preferably less than 0.04 µm, since the capability of the polishing composition for polishing the barrier film 14 improves.

The content of silicon dioxide in the polishing composition is preferably 0.01% by mass or more, more preferably 0.1% by mass or more, since the capability of the polishing composition for polishing the insulating film 13 and barrier film 14 improves. At the same time, the content of silicon dioxide is preferably 20% by mass or less, more preferably 10% by mass cr less, since the capability of the polishing composition for inhibiting the occurrence of dishing and fang improves.

When silicon dioxide in the polishing composition is a mixture of a first silicon dioxide and a second silicon dioxide, the content of the first silicon dioxide in the polishing composition may be higher than that of the second silicon dioxide, or the content of the second silicon dioxide may be higher than that of the first silicon dioxide. When the content of the first silicon dioxide is higher than that of the second silicon dioxide, the capability of the polishing composition for polishing the insulating film 13 improves greater than the capability of the polishing composition for polishing the barrier film 14. When the content of the second silicon dioxide is higher than that of the first silicon dioxide, the capability of the polishing composition for polishing the barrier film 14 improves greater than the capability of the polishing composition for polishing the insulating film 13.

The acid contained in the polishing composition acts to enhance capability of the polishing composition for polishing the barrier film 14. The acid may be an inorganic acid or organic acid. The acid is preferably at least one selected from nitric acid, hydrochloric acid, sulfuric acid, lactic acid, acetic acid, oxalic acid, citric acid, malic acid, succinic acid, butyric acid, and malonic acid; more preferably at least one selected from nitric acid, oxalic acid, and lactic acid; most preferably nitric acid. When the acid contained in the polishing composition is nitric acid, the storage stability of the polishing composition improves and inhibits a reduction over time in the polishing capability of the polishing composition.

The content of the acid in the polishing composition is preferably 0.01% by mass or more, more preferably 0.05% by mass or more, since the capability of the polishing composition for polishing the barrier film 14 improves. When the acid contained in the polishing composition is other than nitric acid, the content of the acid in the polishing composition is preferably 30% by mass or less, more preferably 12% by mass or less, since an excessive decrease in the pH of the polishing composition is inhibited and handleability of the polishing composition is favorably maintained. When the acid contained in the polishing composition is nitric acid, the content of the acid in the polishing composition is preferably 5% by mass or less, more preferably 3% by mass or less, since an excessive decrease in the pH of the polishing composition is inhibited and handleability of the polishing composition is favorably maintained.

The oxidant contained in the polishing composition acts to enhance the capability of the polishing composition for polishing the conductive film 15. By adjusting the content of the oxidant in the polishing composition, the capability of the polishing composition for polishing the conductive film 15 changes, resulting in an increase or decrease in dishing and fang depths. Therefore, the occurrence of dishing and fang can be inhibited depending on how the oxidant content is adjusted. The oxidant may be hydrogen peroxide, persulfate, periodate, perchlorate, nitrate salt, or an oxidative metallic salt. Among them, hydrogen peroxide is preferable, since hydrogen peroxide is easily available and contains only a small amount of metallic impurities. The number of types of oxidants in the polishing composition may be one or two or more.

The content of the oxidant in the polishing composition is preferably 0.01% by mass or more, more preferably 0.03% by mass or more, since the capability of the polishing composition for polishing the conductive film 15 improves. At the same time, the content of the oxidant is preferably 20% by mass or less, more preferably 5% by mass or less, since excessive polishing of the conductive film 15 is inhibited and thereby Lhe occurrence of dishing is inhibited.

Water in the polishing composition serves to dissolve or disperse therein other components in the polishing composition. It is preferred that the water contain the smallest possible amount of impurities so as not to disturb other components. Specifically, pure water treated with ion-exchanging resin to remove impurity ions and subsequently filtered to remove foreign matter, ultrapure water or distilled water is preferable.

The polishing composition is prepared by mixing the surface irregularity-inhibitor, silicon dioxide, acid, oxidant, and water.

The polishing composition according to the present embodiment may be provided for use after dilution with water. In this case, it is preferred that a dispersion stabilizer such as a surfactant be added to the polishing composition before dilution to inhibit agglomeration of the silicon oxide in the polishing composition before dilution.

The polishing composition is preferably kept at a pII of 1.5 or more, more preferably 2 or more, since the handleability of the polishing composition can be favorably maintained. At the same time, the pH of the polishing composition is preferably kept at 4 or less, more preferably 3 or less, since the capability of the polishing composition for polishing the barrier film 14 improves. The pH of the polishing composition may be adjusted by increasing or decreasing the acid content.

The polishing composition may further contain a corrosion inhibitor, which acts to protect the surface of the conductive film 15 from corrosion by an acid. The corrosion inhibitor also acts to inhibit the occurrence of dishing and fang by inhibiting excessive polishing of the conductive film 15. The corrosion inhibitor in the polishing composition may contain at least one selected from benzotriazole, benzimidazole, triazole, imidazole, tolyltriazole, and a derivative thereof. Among them, benzotriazole and a derivative thereof are preferable, since they have a particularly stronger effect of protecting the conductive film 15. Examples of the benzotriazole derivatives include 1-(1,2-dicarboxyethyl)benzotriazole, 1-[N, N-bis (hydroxyethyl) aminomethyl] benzotriazole, 1-(2,3-dihydroxypropyl)benzotriazole, and 1-(hydroxymethyl)benzotriazole.

The content of the corrosion inhibitor in the polishing composition is preferably 0.001% by mass or more, more preferably 0.01% by mass or more, since the capability of the polishing composition for inhibiting the occurrence of dishing and fang improves. At the same time, the content of the corrosion inhibitor is preferably less than 0.5% by mass, more preferably less than 0.3% by mass, since the capability of the polishing composition for polishing the conductive film 15 is favorably maintained.

The polishing composition may further contain if required a chelating agent, thickening agent, emulsifier, rust-inhibitor, preservative, fungicide, defoaming agent or the like.

The present embodiment has the following advantages.

A polishing composition according to the present embodiment contains a surface irregularity-inhibitcr, which acts to inhibit the occurrence of dishing and fang, and an acid and an oxidant, which act to improve polishing capability of the polishing composition. The polishing composition of the present embodiment can realize both an improvement in the polishing capability and inhibition of the occurrence of dishing and fang. Therefore, the polishing composition is useful in polishing for forming wiring a semiconductor device.

Next, examples and comparative examples of the present invention will be described.

Table 1 provides compositions that were mixed with water to prepare polishing composition according to each of Examples 1 to 15 and Comparative Examples 1 to 11. Table 1 also provides pH of each of the polishing composition according to each of Examples 1 to 15 and Comparative Examples 1 to 11.

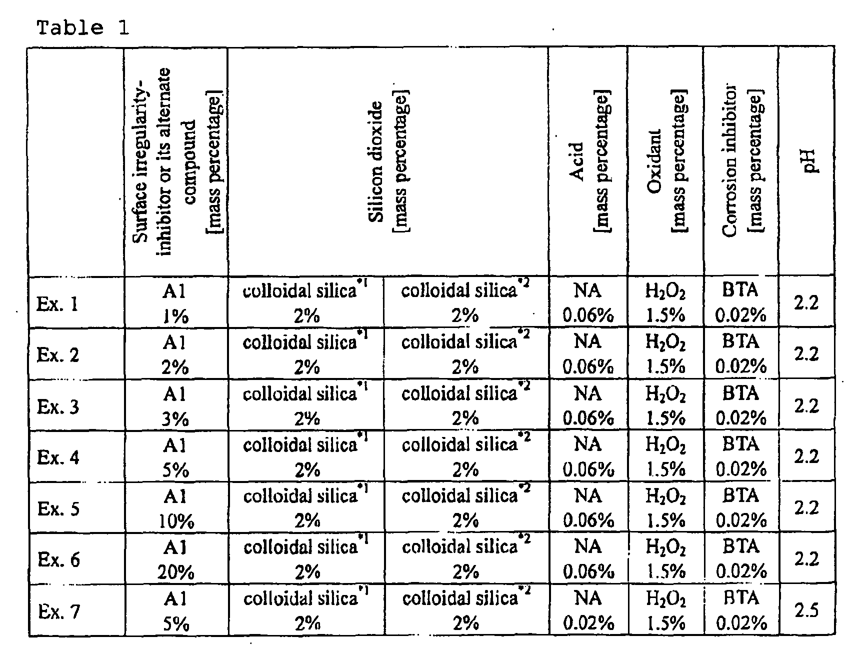

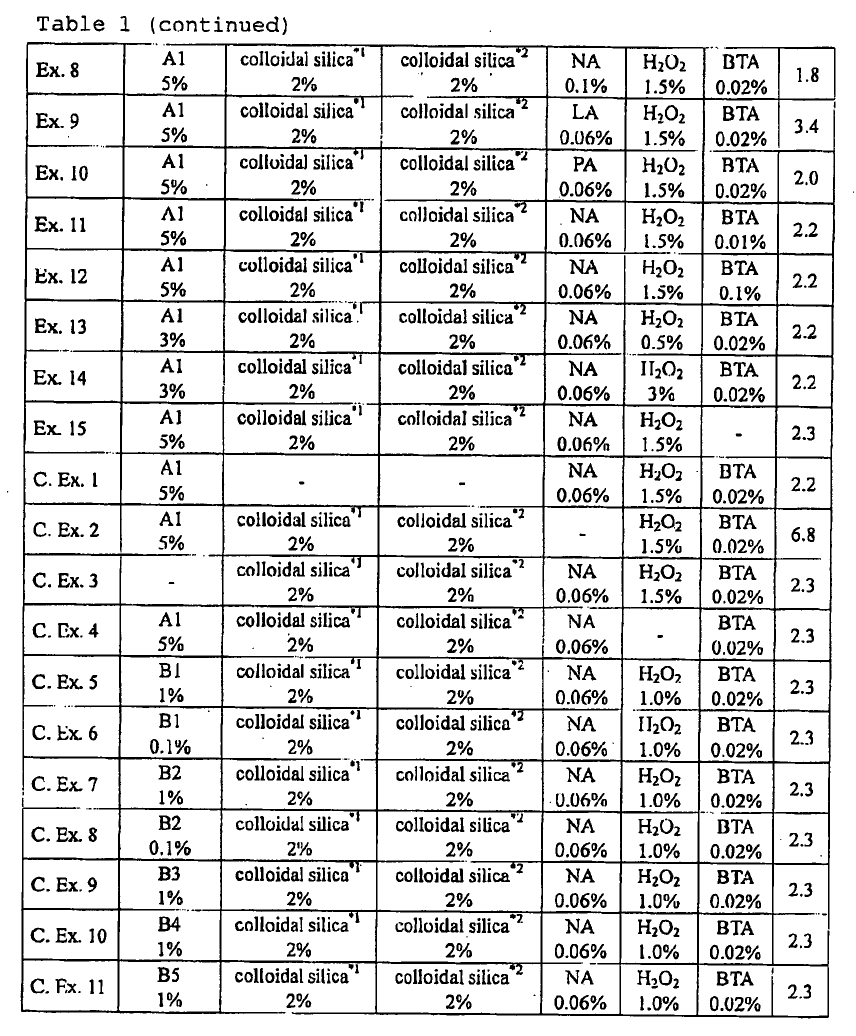

In the "Surface irregularity-inhibitor or its alternate compound" column in Table 1:
"A1" represents pullulan having a molecular weight of 200,000;
"B1" represents a completely saponified polyvinyl alcohol having a molecular weight of 100,000;
"B2" represents a completely saponified polyvinyl alcohol having a molecular weight of 10,000;
"B3" represents polyacrylic acid having a molecular weight of 1000;
"B4" represents ammonium lauryl sulfate have a molecular weight of 283; and
"B5" represents polyethyleneglynol having a molecular weight of 2,000.

In the "Silicon dioxide" column in Table 1:
"colloidal silica^{*1}" represents a colloidal silica having an average particle diameter D_{N4} of 0.07 µm; and
"colloidal silica^{*2}" represents a colloidal silica having an average particle diameter D_{N4} of 0.03 µm.

The average particle diameter D_{N4} was measured by laser diffraction scattering method using an "N4 Plus Submicron Particle Sizer" manufactured by Beckman Coulter Inc.

In the "Acid" column in Table 1:
"NA" represents nitric acid;
"LA" represents lactic acid; and
"PA" represents phosphoric acid.

In the "Oxidant" column in Table 1:
"H₂O₂" represents hydrogen peroxide.

In the "Corrosion inhibitor" column in Table 1:
"BTA" represents benzotriazole.

First, a copper-patterned wafer manufactured by SEMATECH Corporation (mask pattern 854) was polished with a copper-polishing slurry. The wafer comprised an insulating film having trenches, a barrier film and copper film (thickness: 1000 nm) provided on the insulating film in this order, and had 800 nm-deep initial cavities on the top surface. The polishing with the copper-polishing slurry was terminated, when the top surface of the barrier film was exposed. This corresponds to the CMP process of the first polishing step. Then, the wafer was polished with the polishing compositions prepared in Examples 1 to 15 and Comparative Examples 1 to 11 under the following polishing conditions. This corresponds to the CMP process of the second polishing step.

### <Polishing condition>

Polishing machine: Single-sided polishing machine for CMP ,"Mirra" manufactured by Applied Materials Inc.
Polishing pad: Laminated polishing pad of polyurethane "IC-1000/Suba400" manufactured by Rodel Inc.
Polishing pressure: 2psi (= about 13.8 kPa)
Turntable rotation speed: 80 revolution/minute
Polishing composition supplied speed: 200 ml/minute
Head rotation speed: 80 revolution/minute
Polishing time: 1 minute

The copper-patterned wafer polished with the copper-polishing slurry, and the polished wafer further polished with the polishing composition prepared in each of Examples 1 to 15 and Comparative Examples 1 to 11 were measured for the dishing and fang depths in the region where the 100 µm wide trenches were formed by a contact type surface measuring device, profiler "HRP340" manufactured by KLA-Tencor Corporation. The polishing compositions were rated on a scale of one to four according to the dishing depth difference, obtained by subtracting from the dishing depth measured on the wafer polished with the copper-polishing slurry, the dishing depth measured on the wafer further polished with the polishing composition prepared in each Example or Comparative Example: Very good (1); good (2); Slightly poor (3); Poor (4). Specifically, the polishing composition was rated very good when the dishing depth difference was 0 nm or more; it was rated good when the dishing depth difference was -10 nm or more and less than 0 nm; it was rated slightly poor when the dishing depth difference was -20 nm or more and less than -10 nm; it was rated poor when the dishing depth difference was less than -20 nm. The results are given in the column "Dishing" in Table 2. The polishing compositions were also rated on a scale of one to four according to the fang depth difference, obtained by subtracting from the fang depth measured on the wafer polished with the copper-polishing slurry, the fang depth measured on the wafer further polished with the polishing composition prepared in each Example or Comparative Example: Very good (1); Good (2); Slightly poor (3); Poor (4). Specifically, the polishing composition was rated very good when the fang depth difference was 0 nm or more; it was rated good when the fang depth difference was -10 nm or more and less than 0 nm; it was rated slightly poor when the fang depth difference was -20 nm or more and less than -10 nm; it was rated poor when the fang depth difference was less than -20 nm. The results are given in the column "Fang" in Table 2. The dishing and fang depths of the copper-patterned wafer polished with the copper-polishing slurry were 30 and 0 nm, respectively.

The copper-patterned wafer polished with the polishing composition prepared in each of Examples 1 to 15 and Comparative Examples 1 to 11 was analyzed by a scanning probe microscope, "Nanoscope III" manufactured by Digital Instruments, for surface roughness Ra of the copper film remaining on the insulating film, i.e., surface roughness Ra of the copper wiring. The polishing compositions were also rated on a scale of one to four according to the measured surface roughness Ra: Very good (1); Good (2); Slightly poor (3); Poor (4). Specifically, the polishing composition was rated very good when the surface roughness Ra was less than 1.0 nm; it was rated good when the surface roughness Ra was 1.0 nm or more and less than 1.5 nm; it was rated slightly poor when the surface roughness Ra was 1.5 nm or more and less than 2.0 nm; it was rated poor when the surface roughness Ra was 2.0 nm or more. The results are given in the column "Surface roughness" in Table 2.

A copper (Cu), tantalum (Ta), tantalum nitride (TaN), silicon dioxide (SiO₂) and Black Diamond (R) blanket wafers were polished with the polishing composition prepared in each of Examples 1 to 15 and Comparative Examples 1 to 11. The copper blanket wafer was an 8-inch silicon wafer coated with a copper film by electroplating method. The tantalum blanket wafer was an 8-inch silicon wafer coated with a tantalum film by sputtering method. The tantalum nitride blanket wafer was an 8-inch silicon wafer coated with a tantalum nitride film by sputtering method. The silicon dioxide blanket wafer was an 8-inch silicon wafer coated with a silicon dioxide film by CVD with TEOS. The Black Diamond (R) blanket wafer, manufactured by Applied Materials Inc., was an 8-inch silicon wafer coated with a low-k (low dielectric constant) material.

Thickness of each wafer was measured before and after polishing, to determine its stock removal rate by the following calculation formula. The results are given in the column "Stock removal rate" in Table 2. Thicknesses of the copper, tantalum and tantalum nitride blanket wafers were measured by a sheet resistance device "VR-120" manufactured by Kokusai Electric System Service Co., Ltd.. The thicknesses of the silicon dioxide and Black Diamond blanket wafers were measured by an optical film thickness measurement devi.ce, "VM-2030" manufactured by Dainippon Screen Mfg Co., Ltd..

### <Calculation formula>

Stock removal rate [nm/minute] = (thickness of wafer before polishing [nm] - thickness of wafer after polishing [nm]) ÷ polishing time [minute]

About 30 mL of thc polishing composition prepared in each of Examples 1 to 15 and Comparative Examples 1 to 11 was put in a transparent reagent bottle and shaken for about 1 minute. Then, the transparent reagent bottle was allowed to stand, and foaming conditions of the polishing composition were observed. The polishing compositions were rated on a scale of one to four according to the observed foaming conditions: Very good (1); Good (2); Slightly poor (3); Poor (4). Specifically, the polishing composi.tion was rated very good when no foaming was observed after the bottle was left to stand; it was rated good when foaming was observed immediately after the bottle was allowed to stand, but disappeared within 1 minute; it was rated slightly poor when forming was observed in more than 1 minute but disappeared within 10 minutes; it was rated poor when foaming was observed for more than 10 minutes. The results are given in the column "Foaming tendency" in Table 2.

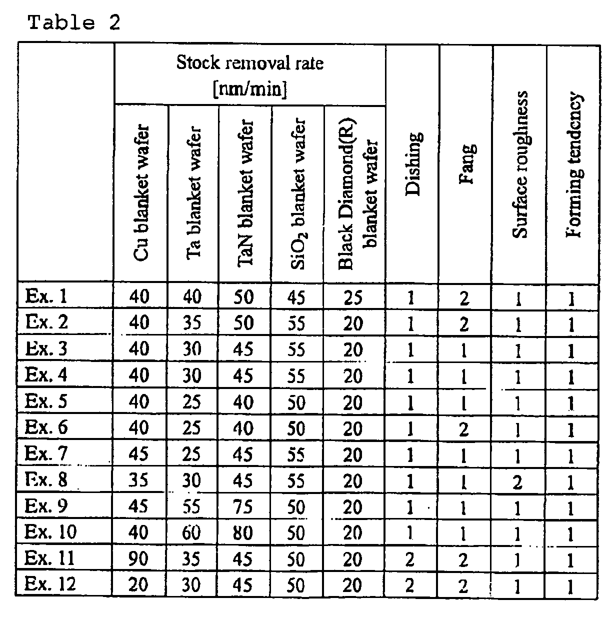

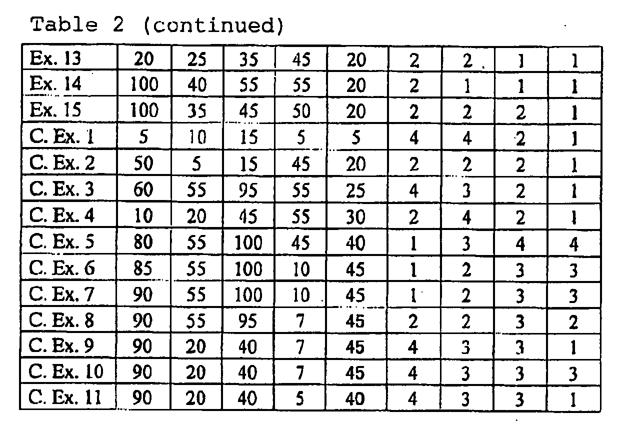

It was found, as shown in Table 2, that the polishing composition prepared in each of Examples 1 to 15 was rated "Very good" or "Good" with respect to dishing and fang, and that it can inhibit the occurrence of dishing and fang. It was also found that each of the polishing composition in Examples 1 to 15 had a high polishing capability, since each exhibited a stock removal rate of 20 nm/minute or more for each wafer tested. In addition, each polishing composition in Examples 1 to 15 was rated "Very good" or "Good" with respect to the surface roughness and foaming tendency. These results suggest that the polishing composition prepared in each of Examples 1 to 15 is useful in polishing for forming semiconductor device wiring.

By contrast, the polishing composition prepared in each of Comparative Examples 1 to 11 was rated "Slightly poor" or "Poor" with respect to either dishing or fang, or exhibited an insufficient stock removal rate of less than 20 nm/minute for one of the wafers tested. It is therefore found that the polishing composition prepared in each of Comparative Examples 1 to 11 cannot simultaneously realize inhibition of the occurrence of dishing and fang, and exhibition of a sufficient stock removal rate.

## Claims

1. A polishing composition for use in polishing for forming wiring in a semiconductor device, the polishing composition **characterized by** a surface irregularity-inhibitor, silicon dioxide, an acid, an oxidant, and water.

2. The polishing composition according to Claim 1, **characterized in that** the surface irregularity-inhibitor is at least one selected from stored polysaccharides and extracellular polysaccharides.

3. The polishing composition according to Claim 2, **characterized in that** the surface irregularity-inhibitor is pullulan.

4. The polishing composition according to Claim 3, **characterized in that** the pullulan has a molecular weight of 100,000 to 300,000.

5. The polishing composition according to any one of claims 1 to 4, **characterized in that** content of the surface irregularity-inhibitor in the polishing composition is 0.001 to 30% by mass.

6. The polishing composition according to Claim 1, **characterized in that** the silicon dioxide is colloidal silica.

7. The polishing composition according to any one of claims 1 to 6, **characterized in that** the silicon dioxide has an average particle diameter of 0.01 µm or more and of less than 0.5 µm as determined by a laser diffraction scattering method.

8. The polishing composition according to any one of claims 1 to 6, **characterized in that** the silicon dioxide contains a first silicon dioxide and a second silicon dioxide, the two having different average particle diameters from each other.

9. The polishing composition according to Claim 8, **characterized in that** the first silicon dioxide has an average particle diameter of 0.05 µm or more and of 0.3 µm or less as determined by a laser diffraction scattering method, and the second silicon dioxide has an average particle diameter of 0.01 µm or more and of less than 0.05 µm as determined by a laser diffraction scattering method.

10. The polishing composition according to any one of claims 1 to 9, **characterized in that** content of the silicon dioxide in the polishing composition is 0.01 to 20% by mass.

11. The polishing composition according to any one of claims 1 to 10, **characterized in that** the acid is at least one selected from nitric acid, hydrochloric acid, sulfuric acid, lactic acid, acetic acid, oxalic acid, citric acid, malic acid, succinic acid, butyric acid, and malonic acid.

12. The polishing composition according to Claim 11, **characterized in that** the acid is nitric acid.

13. The polishing composition according to any one of claims 1 to 11, **characterized in that** content of the acid in the polishing composition is 0.01 to 30% by mass.

14. The polishing composition according to Claim 1, **characterized in that** the oxidant is hydrogen peroxide.

15. The polishing composition according to any one of claims 1 to 14, **characterized in that** content of the oxidant in the polishing composition is 0.01 to 20% by mass.

16. The polishing composition according to any one of claims 1 to 15, further **characterized by** a corrosion inhibitor.

17. The polishing composition according to Claim 16, **characterized in that** the corrosion inhibitor is benzotriazole or its derivative.

18. The polishing composition according to any one of claims 1 to 17, **characterized in that** the pH of the polishing composition is 1.5 to 4.

19. A polishing method **characterized by**:
preparing the polishing composition according to any one of claims 1 to 18; and
polishing a subject to be polished using the prepared polishing composition in order to form wiring in a semiconductor device.

20. The method according to Claim 19, **characterized in that** the subject to be polished comprises an insulating film having trenches, a barrier film and a conductive film provided in this order on the insulating film, each of the barrier and conductive films having a portion located inside the trenches and a portion located outside the trenches,
the step of polishing the subject to be polished comprises a sub-step of removing a part of the portion of the conductive film located outside of the trenches in order to expose the top surface of the barrier film, and a sub-step of removing a remaining part of the portion of the conductive film located outside the trenches and the portion of the barrier film located outside the trenches, in order to expose the top surface of the insulating film, and
the polishing composition is used in the step of removing the remaining part of the portion of the conductive film located outside the trenches and the portion of the barrier film located outside the trenches.
